# EUROPEAN PATENT APPLICATION

(11) **EP 1 840 914 A1**
(43) Date of publication of application: **03.10.2007**
(21) Application number: 06711764.8
(22) Date of filing: 17.01.2006
(51) Int. Cl.: H01G 4/33, H01G 4/12, H05K 1/16, H05K 1/18, H05K 3/46

(54) **CAPACITOR LAYER FORMING MATERIAL, PROCESS FOR PRODUCING THE SAME, AND PRINTED WIRING BOARD HAVING BUILT-IN CAPACITOR LAYER OBTAINED USING THE MATERIAL**

(30) Priority: 17.01.2005 JP 2005009595
(71) Applicant: MITSUI MINING & SMELTING CO., LTD., Tokyo 141-8584 (JP)
(72) Inventor: ABE, Naohiko, MITSUI MINING&SMELTING CO., LTD., Ageo-shi, Saitama 36200 21 (JP); SUGIOKA, Akiko, MITSUI MINING&SMELTING CO., LTD, Ageo-shi, Saitama 36200 21 (JP); KANNO, Akihiro, MITSUI MINING&SMELTING CO., LTD, Ageo-shi, Saitama, 36200 21 (JP)
(74) Representative: Bohmann, Armin K.
(86) International application number: PCT/JP2006/300484
(87) International publication number: WO 2006/075751

(57) **Abstract**

The object of the present invention is to provide a capacitor layer forming material of an oxide dielectric film formed by means of a sol-gel process which is excellent in manufacturing cost advantage and which can manufacture a capacitor circuit having higher electric capacitance than ever before with a long life. In order to attain this object, a capacitor layer forming material 1 comprising a dielectric layer 4 between a first electrically conductive layer 2 used for forming a top electrode and a second electrically conductive layer 3 used for forming a bottom electrode, the capacitor layer forming material **characterized in that** the dielectric layer 4 is an oxide dielectric film formed by means of a sol-gel process which has an enlarged crystal texture grown in the thickness direction and the plane direction of the dielectric layer and includes an oxide crystal texture whose grain size (longitudinal diameter) is 50 nano meter to 300 nano meter is adopted. In addition, a manufacturing method for effectively obtaining the capacitor layer forming material is also provided.

## Description

### Technical Field

The invention according to the present application relates to a capacitor layer forming material, and a manufacturing method thereof, and a printed wiring board with an embedded capacitor layer obtained using the capacitor layer forming material.

### Background Art

The capacitor layer forming material as used in the present invention refers to a material constituted from a dielectric layer between a first electrically conductive layer used for forming a top electrode anda second electrically conductive layer used for forming a bottom electrode. In addition, the first electrically conductive layer and the second electrically conductive layer are processed so as to form a capacitor circuit by means of processing such as etching, and as disclosed in Patent Document 1, in general, they are used as a material constituting an electronic material such as a printed wiring board.

In addition, the dielectric layer has an insulating property and a function of storing a certain amount of electric charges. With regard to methods for forming such a dielectric layer, various kinds of methods are adopted. However, a chemical vapor deposition process (CVD process), a sputter deposition process, and, a sol-gel process are usually used. For example, Patent Document 2, as a method using the chemical vapor deposition process, discloses a manufacturing method including a step of depositing an amorphous SrTiO₃-based thin film on an underlying layer at a temperature lower than 400 deg. C and a step of obtaining an SrTiO₃-based thin film by crystallizing the amorphous SrTiO₃-based thin film by subjecting the amorphous SrTiO₃-based thin film to laser annealing or rapid thermal annealing. The dielectric layer obtained by the manufacturing method has an object to obtain a SrTiO₃-based thin film having a high dielectric constant.

Next, Patent Document 3, as a capacitor using a sputter deposition process, discloses a thin film capacitor, in which a bottom electrode, dielectric with a high dielectric constant, and a top electrode are laminated on an arbitrary layer of a substrate, characterized in that, the dielectric with a high dielectric constant is a polycrystal composed of grains and grain boundaries and contains metal ions that can take plural valence states as impurities whose concentrations are higher at the vicinity of the boundaries than at the inside of the grains, and it discloses that Mn ion is preferable as the metal ion which take plural valence states. It describes that a thin film capacitor obtained by the manufacturing method has a long-term reliability and takes long time until its dielectric breakdown occurs.

Furthermore, in Patent Document 4, as a manufacturing method using a sol-gel process, a manufacturing method of an oxide dielectric thin film is disclosed, where the surface of a substrate is subjected to hydroxylation treatment, and subsequently, an oxide dielectric thin film using a metal alkoxide as a raw material is formed on the substrate. Here, it is described that the oxide dielectric which can be formed as a thin film is a metal oxide with dielectric properties, and, for example, LiNbO₃, Li₂B₄O₇, PbZrTiO₃, BaTiO₃, SrTiO₃, PbLaZrTiO₃, LiTaO₃, ZnO, or Ta₂O₅ is used. In addition, it is described that the oxide dielectric thin film obtained by the manufacturing method has an excellent orientation property and good crystallinity.

Patent Document 1 : National Publication of International Patent Application No. 2002-539634
Patent Document 2: Japanese Patent No. 3108797
Patent Document 3: Japanese Patent Laid-Open No. 2001-358303
Patent Document 4: Japanese Patent Laid-Open No. H07-294862

### Disclosure of the Invention

However, the formation of dielectric layer by means of a CVD process or a sputter deposition process disclosed in Patent Documents 2 and 3 have problems such as large capital investment cost caused by usage of a vacuum process, difficulty in forming a metal oxide thin film, as a dielectric layer, on a large area substrate, and lack of economic efficiency because of expensive price.

On the contrary, advantages of the sol-gel process disclosed in Patent Document 4 are that the dielectric layer can be formed even on a large-area substrate, and that, since the dielectric layer can be manufactured by only coating and heating processes, the manufacturing cost is low. Meanwhile, disadvantage of the dielectric film manufactured by means of the sol-del process is that poor adhesion between the dielectric film and a base material, etc. and thereby, delamination between them tends to occur. In order to eliminate the disadvantage, an attempt such as miniaturizing of grains of an coated oxide film manufactured is made by means of the sol-gel process of forming a dielectric layer, but a leakage current, an electric property as a dielectrics, tends to be larger, and thereby, dielectric breakdown tends to occur earlier.

Since a capacitor circuit has generally enabled electric power saving of electronic and electric equipment by means of storing redundant electricity and the like, it is required for the capacitor to have electric capacitance as large as possible as a basic quality. The capacitance (C) of the capacitor is calculated by the formula: C = ε ε₀ (A/d) (ε₀ is a dielectric constant of vacuum). In particular, from the trend of down-sizing in recent electronic and electric equipment, the similar demand is also made to a printed wiring board, and it is thereby, clear that it is almost impossible to make the area of a capacitor electrode wider in a certain area of a substrate such as a printed wiring board, and there is thus a limitation for improving the surface area (A). In particular, in recent electronic and electric products, in order to store a higher volume of electric charges in a smaller area, it is required to increase the capacitance of the capacitor without increasing the area of the capacitor circuit.

From the above mentioned situation, in the market, a capacitor layer forming material with which a capacitor circuit having higher electric capacitance with a longer life than ever before can be manufactured has been demanded.

Therefore, in the present invention, it is investigated out that, by adopting an oxide dielectric film which is formed by means of a sol-gel process mentioned below and whose grain size is large, the above mentioned problem can be eliminated.

Capacitor layer forming material according to the present invention:
Regarding to basic constitution of a capacitor layer forming material according to the present invention, the capacitor layer forming material includes a dielectric layer between a first electrically conductive layer used for forming a top electrode and a second electrically conductive layer used for forming a bottom electrode, and is characterized in that the dielectric layer is an oxide dielectric film formed by means of a sol-gel process, has an enlarged crystal texture grown in the thickness direction and the plane direction of the dielectric layer, and includes an oxide crystal texture whose grain size (longitudinal diameter) is 50 nano meter to 300 nano meter.

In addition, it is preferable for the oxide dielectric film constituting the dielectric layer to contain one or mixture selected from manganese, silicon, nickel, aluminum, lanthanum, niobium, and magnesium at an amount of 0.01 mol% to 3.00 mol%.

It is preferable for the dielectric layer of the capacitor layer forming material according to the present invention to have a thickness of 20 nano meter to 1 micron meter.

In addition, it is preferable for the oxide dielectric film constituting the capacitor layer forming material according to the present invention to use any one of a (Baᵢ₋ₓSrₓ)TiO₃ (0 ≦ x ≦ 1) film and a BiZrO₃ film.

It is preferable for the second electrically conductive layer of the capacitor layer forming material according to the present invention to use a nickel layer or a nickel alloy layer whose thickness is 10 micron meter to 100 micron meter.

In addition, it is preferable for the nickel alloy layer to use a nickel-phosphorus alloy.

Manufacturing method of the capacitor layer forming material according to the present invention:
It is preferable for the capacitor layer forming material according to the present invention to be manufactured by adopting a manufacturing method of the capacitor layer forming material characterized by including the following steps (a) to (d).

(a) a solution preparing step of preparing a sol-gel solution for manufacturing a desired oxide dielectric film; and
(b) a coating step to adjust a film thickness by repeating plurality of times of a step which include coating of the sol-gel solution on the surface of a metal foil to be a second electrically conductive layer, drying of the coated solution under conditions of an oxygen containing atmosphere at a temperature of 120 deg. C to 250 deg. C for 1 minute to 10 minutes, and pyrolyzing under conditions of an oxygen containing atmosphere at a temperature of 290 deg. C to 390 deg. C for 5 minutes to 30 minutes; and
(c) a baking step to complete a dielectric layer by subjecting the film to baking treatment under conditions of an inert-gas replaced atmosphere, at a temperature of 550 deg. C to 800 deg. C for 10 minutes to 40 minutes; and
(d) a first electrically conductive layer forming step to complete a capacitor layer forming material by forming a first electrically conductive layer on the obtained dielectric layer.

Printed wiring board using the capacitor layer forming material according to the present invention:
The capacitor layer forming material according to the present invention can be suitably used for forming an embedded capacitor layer of a multilayer printed wiring board.

By using an oxide dielectric film that includes enlarged oxide grains formed by means of a sol-gel process as a dielectric layer locating between a first electrically conductive layer and a second electrically conductive layer of a capacitor layer forming material according to the present invention, it is possible to reduce the leakage current of a capacitor circuit manufactured by using the capacitor layer forming material, and to achieve high capacitance and life-span extension of the capacitor circuit. Further, by having the oxide dielectric film that contains 0.01 mol% to 3.00 mol% of manganese, it is possible to reduce the leakage current further, and to achieve life-span extension of the capacitor circuit. Moreover, by adopting the manufacturing method of the capacitor layer forming material according to the present invention, it is also possible to efficiently manufacture the capacitor layer forming material by using the sol-gel process.

### Brief Description of the Drawings

Figure 1 is a schematic cross sectional view of the crystal texture of a dielectric layer formed by means of a sol-gel process of a capacitor layer forming material according to the present invention;
Figure 2 is a schematic cross sectional viewof the crystal texture of a dielectric layer formed by means of a sol-gel process of a capacitor layer forming material (conventional example);
Figure 3 is an observed image of the cross section of the capacitor layer forming material when being subjected to focused ion beam processing, and observed using a transmission electron microscope in magnification of 1000,000; and
Figure 4 is an observed image of the cross section of the capacitor layer forming material when being subjected to focused ion beam processing, and observed using the transmission electron microscope in magnification of 1000,000 (conventional example).

### Reference Numerals

- 1: CAPACITOR LAYER FORMING MATERIAL
- 2: FIRST ELECTRICALLY CONDUCTIVE LAYER
- 3: SECOND ELECTRICALLY CONDUCTIVE LAYER
- 4: DIELECTRIC LAYER
- 5: ENLARGED CRYSTAL PART
- 6: FINE CRYSTAL PART

### Best Mode for Carrying Out the Invention

### (Embodiments of a capacitor layer forming material according to the present invention)

Regarding to basic constitution of a capacitor layer forming material according to the present invention, the capacitor layer forming material includes a dielectric layer between a first electrically conductive layer used for forming a top electrode and a second electrically conductive layer used for forming a bottom electrode, and is characterized in that the dielectric layer is an oxide dielectric film formed by means of a sol-gel process, has an enlarged crystal texture grown in the thickness direction and the plane direction of the dielectric layer, and includes an oxide crystal texture whose grain size (longitudinal diameter) is 50 nano meter to 300 nano meter.

Dielectric layer:
It is required for the dielectric layer of the capacitor layer forming material to have high electric capacitance for storing a high volume of electric charges, and a leakage current from the stored charges is preferable to be as small as possible. Accordingly, inventors of the present invention prepared a capacitor circuit by using a capacitor layer forming material with the same constitution as that of the capacitor layer forming material according to the present invention to verify easiness and mechanism of occurrence of leakage current. As the results, it has been found that there is high possibility that when an oxide dielectric film formed by means of a sol-gel process is used as a dielectric layer, a leakage current flows through grain boundaries and lattice defects of the oxide dielectric film. In other words, the leakage current tends to be larger when the texture of the oxide dielectric film is fine and there are many gain boundaries. On the contrary, the leakage current is small when the texture of the oxide dielectric film is enlarged in a certain range and there are a few grain boundaries, thus it has been found that a high capacitance dielectric layer can be obtained.

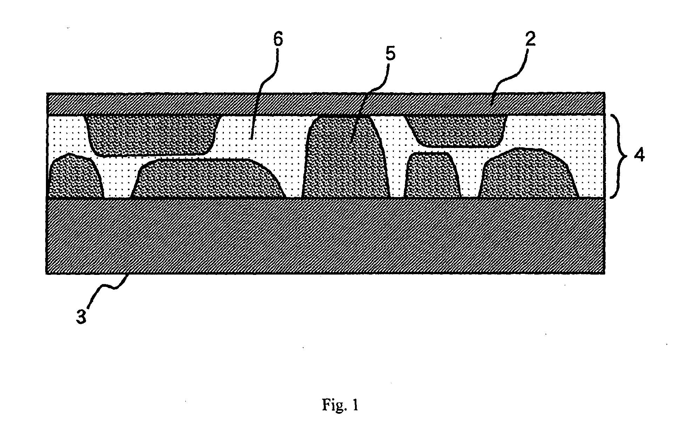

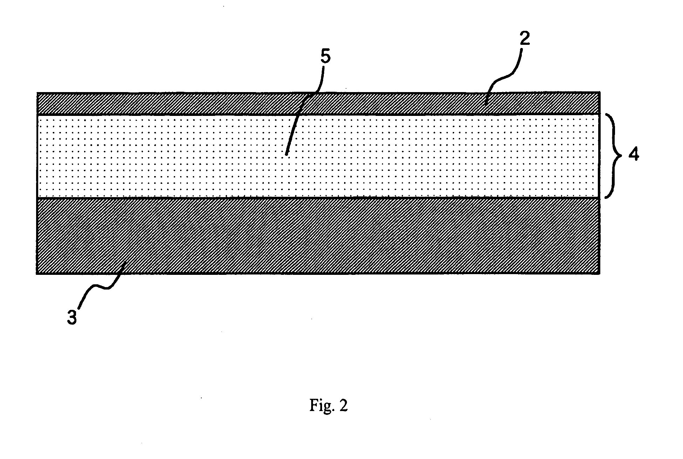

Accordingly, in the capacitor layer forming material according to the present invention, it is preferable for the oxide dielectric film constituting the dielectric layer to be grown in the thickness direction or the plane direction thereof and to include an oxide crystal texture whose grain size (longitudinal diameter) is 50 nano meter to 300 nano meter. Here, the state of the crystal texture of a dielectric layer 4 between a top electrode 2 and a bottom electrode 3 will be described with reference to Figures 1 and 2 schematically showing the state. Figure 1 is a view showing an image of the dielectric layer of the capacitor layer forming material according to the present invention. On the contrary, Figure 2 is a view schematically showing the crystalline state of an oxide dielectric film obtained by a conventional sol-gel process.

Since in the crystalline state of the oxide dielectric film obtained by the conventional sol-gel process, as shown in Figure 2, fine grains are present, even if a transmission electron microscope is used, grain boundaries cannot be observed clearly, thus, resulting in increase of grain boundaries to be channels of leakage current between the top electrode 2 and the bottom electrode 3. It is difficult to show the state of the grain boundary of a fine grain part 6 on the drawing, and may be recognized as a single layer, but by X-ray diffractiometry, it can be confirmed that the fine grain part has certain crystallinity. On the contrary, the crystal texture of the dielectric layer of the capacitor layer forming material according to the present invention includes enlarged grain parts 5 as shown in Figure 1. In a case of such a crystal texture, grain boundaries that probably act as channels of leakage current between the top electrode 2 and the bottom electrode 3 will decrease. Then, according to confirmation of the inventors of the present invention, when the enlarged crystal texture of the dielectric layer is grown in the thickness direction and the plane direction of the dielectric layer, and an oxide crystal texture whose grain size (longitudinal diameter) is 50 nano meter to 300 nano meter is included, it has been found that leakage current decrease, and the dielectric layer has a high electric capacitance, and further life-span extension enabling long-term usage thereof could be achieved. With regard to the grain size as used here, it is the size of grain that is the measured longitudinal diameter of an enlarged grain directly investigated in the observed image when the cross section of the capacitor layer forming material is processed by a focused ion-beam and observed in magnification of 1000, 000 using a transmission electron microscope, and thereby it cannot be said to be the grain diameter in a strict meaning; however, as an index for clarifying existence of enlarged grains, it is satisfactory in any way.

Here, when only an oxide crystal texture whose grain size (longitudinal diameter) is less than 50 nano meter, is present, as compared to the oxide dielectric film obtained by the conventional sol-gel process, decrease of leakage current and increase of electric capacitance are also not significant. Meanwhile, in order to obtain grains of oxide crystal texture whose grain size (longitudinal diameter) is greater than 300 nano meter, very specific manufacturing conditions have to be used, and thereby, in the range of grains, production in industrial scale is substantially impossible.

In addition, it is preferable for the oxide dielectric film to contain one or mixture selected from manganese, silicon, nickel, aluminum, lanthanum, niobium, and magnesium in the grain boundaries and grains thereof. It is preferable to use manganese among them. The manganese is considered to exist as manganese oxide inside the dielectric film, has important purpose to be segregated in grain boundaries of the oxide dielectric film obtained by means of the sol-gel process and is used for blocking channels of leakage current. At that time, the amount of manganese to be contained in the oxide dielectric film is preferable to be 0.01 mol% to 3.00 mol%. When the amount of manganese is less than 0.01 mol%, segregation of manganese into the grain boundaries of the oxide dielectric film obtained by means of the sol-gel process, is insufficient, and thereby good effect of reducing leakage current is not achieved. On the other hand, when the amount of manganese is more than 3.00 mol%, the segregation of manganese into the grain boundaries of the oxide dielectric film obtained by means of the sol-gel process becomes too much, thereby, the dielectric film becomes brittle and losses toughness, and thus problems tend to occur such as destruction of the dielectric layer by the shower of an etchant or the like when the shape of the top electrode or the like is processed by means of an etching process. Moreover, when the amount of manganese becomes too much, there is also a tendency that the growth of oxide crystal texture in a manufacturing method described below is suppressed. Accordingly, by adopting composition containing manganese within the above mentioned range, the electric capacitance as a capacitor increases largely, and the leakage current decreases, thus resulting in achievement of life-span extension. In addition, it is more preferable for the amount of manganese contained in the oxide dielectric film to be 0.25 mol% to 1.50 mol%. It is for securing the quality of an oxide dielectric film more surely. Inaddition, the oxide dielectric film is a dielectric film with a perovskite structure, and does not contain manganese oxide without when being clearly indicated that a manganese oxide component is contained in the oxide dielectric film.

Moreover, a case where manganese is substituted in oxide crystal lattice is also assumed. In general, in an oxide dielectric film, oxygen deficiency occurs due to crystallization under low oxygen partial pressure. For this reason the valence of titanium is reduced from 4 to 3, and it is supposed that the insulating property is degraded by electron hopping between titanium atoms each with different valences. However, when a suitable amount of manganese is substituted and dissolved in an oxide crystal, the valence of the manganese is arranged to be 2 to 3, and thereby, oxygen deficiency can be compensated, enabling to expect an effect that the insulating property is improved by avoiding the reduction of titanium.

In addition, it is preferable for the dielectric layer of the capacitor layer forming material according to the present invention to have a thickness of 20 nano meter to 1 micron meter. Since as the thickness of the dielectric layer becomes thinner, the electric capacitance is improved, it is preferable for the thickness to be as thinner as possible, however, when the thickness of the dielectric layer is less than 20 nano meter, even if the size of the oxide crystal of the dielectric layer is large, effect of reducing the leakage current drops, and thereby dielectric breakdown occurs earlier, thus disabling to achieve life-span extension. On the other hand, if a smaller electric capacitance is acceptable, the thickness of the dielectric film can be thicker. However, in consideration of a required value of the electric capacitance of a capacitor circuit, etc. that is demanded in the market, thickness of this order is considered as an upper limit.

In addition, it is preferable for the oxide dielectric film constituting the capacitor layer forming material according to the present invention, to use any one of a (Ba₁₋ₓ Srₓ)TiO₃ (0 ≦ x ≦ 1) film and a BiZrO₃ film. Here, in the (Ba₁₋ₓ Srₓ)TiO₃ (0 ≦ x ≦ 1) film, the case of x = 0 means the composition of BaTiO₃, and the case of x = 1 means the composition of SrTiO₃. However, as an intermediate composition, (Ba_{0.7} Sr_{0.3})TiO₃ or the like may be present.

Second electrically conductive layer (bottom electrode):
In the present invention, a nickel layer or a nickel alloy layer is adopted as the second electrically conductive layer, by the following four reasons. (1) They are available as a metal foil, and, at that state, a dielectric layer can be formed on the surface thereof, by means of a sol-gel process. (2) They are excellent in oxidation resistance and softening resistance with respect to severe thermal history loaded when the dielectric layer is formed by means of a sol-gel process. (3) Adhesion with respect to the dielectric layer can be controllable in a certain level by changing the composition of the nickel alloy. (4) By employing the even layer of the metal components, a fine capacitor circuit when patterning the bottom electrode, can be formed by means of an etching process.

The nickel layer or nickel alloy layer as used here is intended to be mainly used as a metal foil. Accordingly, the nickel layer is a layer formed with a so called pure nickel foil whose purity is equal to or greater than 99.9% (others are unavoidable impurities). And the nickel alloy layer is a layer formed with, for example a nickel-phosphorus alloy. The phosphorus content of the nickel-phosphorus alloy as used here is preferably 0.1 wt% to 11 wt%. It is considered that if high temperature is loaded in a manufacturing process of a capacitor layer forming material and a usual printed wiring board, the phosphorus component of the nickel-phosphorus alloy layer diffuses inside the dielectric layer, thereby degrades the adhesion of the dielectric layer and also gives change to the dielectric constant thereof. However, the nickel-phosphorus alloy layer with proper phosphorus content improves electrical properties as a capacitor. When the phosphorus content is less than 0. 1 wt%, the dielectric layer does not differ from a dielectric layer when pure nickel is used, and thereby, the meaning of alloying is lost. On the other hand, if the phosphorus content is greater than 11 wt%, phosphorus will segregate into the interface between the alloy layer and the dielectric layer, and adhesion between the alloy layer and the dielectric layer will thereby degrade, thus resulting an electrically conductive layer to be easily peeled off. Therefore, it is preferable for the phosphorus content to be within a range of 0.1 wt% to 11 wt%. In addition, in order to ensure more stable adhesion with respect to the dielectric layer, if the phosphorus content is 0.2 wt% to 3 wt%, even when a certain fluctuation is present in the step, it is possible to form a capacitor circuit with a stable quality. In addition, if the optimal range is daringly pointed out, the phosphorus content of 0.25 wt% to 1 wt% ensures the best adhesion with respect to the dielectric layer, and at the same time a good dielectric constant can be also secured. In addition, the nickel content in the present invention is a value converted using the formula: [weight of P component] / [weight of Ni component] x 100 (wt %).

The nickel foil and nickel alloy foil as used in the present invention include all of those obtained by means of a rolling process and an electrolytic process etc. And they are described as a concept also including a material such as a composite foil comprising a nickel layer or a nickel alloy layer as the top surface layer of the metal foil. For example, as a material constituting the second electrically conductive layer, a composite material that is a copper foil comprising the nickel layer or the nickel alloy layer on the surface thereof can also be used.

As long as the metal foil has such physical properties, even if being subjected to high temperature processing at a temperature of 300 deg. C to 400 deg. C in a printed wiring board where as a substrate material, fluorine-contained resin, liquid crystal polymer, or the like, is used, the strength of the metal foil hardly degrades, thereby, resulting in that the quality of a capacitor layer forming material using the metal foil as the second electrically conductive layer also hardly degrades. In addition, it is preferable for the crystal texture of the nickel foil and the nickel alloy foil as used in the present invention, to have grains as small as possible to improve strength. Further, specifically, it is preferable for the physical properties of the texture to have a small average grain size being an order equal to or smaller than 0.5 micron meter with the improved mechanical strength.

In addition, it is preferable for the thickness of the nickel layer and the nickel alloy layer to be 10 micron meter to 100 micron meter. When the thickness is less than 10 micron meter, handling ability as a metal foil is very poor, and thereby, it is very difficult to form a dielectric layer on the surface thereof.

As the nickel foil and the nickel alloy foil used for constituting the second electrically conductive layer as described above, those manufactured by means of an electrolytic process or a rolling process can be used. With regard to the manufacturing method thereof, there is no limitation in particular. Especially, the rolling method is a process constituting adjusting of components in an ingot by means of a metallurgical process and then rolling of the ingot to be a foil shape while subjecting additional suitable annealing, so it is enough to adopt a conventional approach.

On the other hand, in the case of the electrolytic process, deposited metal texture differs depending on the electrolytic solution, electrolysis condition, or the like, and the physical strength thereof is also influenced as the results. However, when a nickel layer is formed, a popular solution as a nickel plating solution can be used widely. For example, conditions such as (i) nickel sulfate is used, nickel concentration: 5 to 30 g/l, solution temperature: 20 to 50 deg. C, pH: 2 to 4, and current density: 0.3 to 10 A/dm²; (ii) nickel sulfate is used, nickel concentration: 5 to 30 g/l, potassium pyrophosphate: 50 to 500 g/1, solution temperature: 20 to 50 deg. C, pH: 8 to 11, and current density: 0.3 to 10 A/dm²; (iii) nickel sulfate is used, nickel concentration: 10 to 70 g/l, boric acid: 20 to 60 g/l, solution temperature: 20 to 50 deg. C, pH: 2 to 4, and current density: 1 to 50 A/dm²; in addition, popular Watt bath condition or the like can be used.

In addition, in the case of manufacturing a nickel-phosphorous alloy foil by means of electrolysis, a phosphate-based solution is used as the electrolytic solution. In this case, conditions such as (i) nickel sulfate concentration: 120 g/l to 180 g/l, nickel chloride concentration: 35 g/l to 55 g/l, H₃PO₄ concentration 3 g/l to 5 g/l, H₃PO₃ concentration 2 g/l to 4 g/l, solution temperature: 70 deg. C to 95 deg. C, pH: 0.5 to 1.5, and current density: 5A/dm²to 50A/dm²; (ii) nickel sulfate concentration: 180 g/l to 280 g/l, nickel chloride concentration: 30 g/l to 50 g/l, H₃BO₃ concentration 16 g/l to 25 g/l, H₃PO₃ concentration 1 g/l to 5 g/l, solution temperature: 45 deg. C to 65 deg. C, and current density: 5 A/dm² to 50 A/dm² are adopted. Moreover, although a commercially available electroless plating solution can also be used to form a nickel-phosphorous alloy layer for means of electroless plating, but the film forming rate of this method does not satisfy industrial productivity.

### (Manufacturing method of the capacitor layer forming material according to the present invention)

It is preferable for the capacitor layer forming material according to the present invention to be manufactured by adopting a manufacturing method of the capacitor layer forming material characterized by including the following steps (a) to (d).

(a) A solution preparing step of preparing a sol-gel solution for manufacturing a desired oxide dielectric film. There is no specific limitation with regard to the step, and accordingly, a commercially available prepared solution may be used, or the solution may be prepared by oneself. As the results, it is sufficient if any one of a desired (Ba₁₋ₓSrₓ)TiO₃ (0 ≦ x ≦ 1) film and BiZrO₃ (0 ≦ x ≦ 1) film can be obtained.

(b) a coating step to adjust a film thickness by repeating plurality of times of a step which includes coating of the sol-gel solution on the surface of a metal foil to be a second electrically conductive layer, drying of the coated solution under conditions of an oxygen containing atmosphere at a temperature of 120 deg. C to 250 deg. C for 1 minute to 10 minutes, and pyrolyzing under conditions of an oxygen containing atmosphere at a temperature of 290 deg. C to 390 deg. C for 5 minutes to 30 minutes. This step is different from a conventional manufacturing method by means of a sol-gel process and is the characteristics in the manufacturing method of this invention. Hereby, with regard to coating means when the metal foil to be the second electrically conductive layer is coated with the sol-gel solution, there is no limitation in particular. However, as long as considering the uniformity of the film thickness and the character of the sol-gel solution, it is preferable to use a spin coater.

In addition, after finishing coating of a sol-gel solution, the coated solution is dried under conditions of an oxygen containing atmosphere at a temperature of 120 deg. C to 250 deg. C for 1 minute to 10 minutes, and the dried film is pyrolyzed under conditions of an oxygen containing atmosphere at a temperature of 290 deg. C to 390 deg. C for 5 minutes to 30 minutes. The drying at that time is performed under conditions of a temperature of 120 deg. C to 250 deg. C for 1 minute to 10 minutes, if the process condition does not fall within the range described above, rough surface of the dielectric film may happen after pyrolyzing because of insufficient drying, if drying is excessive, locational quality fluctuation of the obtained dielectric film may happen because of the insufficient pyrolyzing subsequently performed. When drying and pyrolyzing are performed, it is performed under an oxygen containing atmosphere. In other words, if they are performed under a reducing atmosphere, decomposition of organic material is not promoted.

After finishing above described drying, the dried film is pyrolyzed under conditions of an oxygen containing atmosphere at a temperature of 290 deg. C to 390 deg. C for 5 minutes to 30 minutes. Here, the adopted pyrolyzing temperature is very characteristic. In a conventional pyrolyzing temperature, a temperature range of 450 deg. C to 550 deg. C has been adopted. On the other hand, in the manufacturing method according to the present invention, in order to prevent excessive oxidation of the second electrically conductive layer, a low temperature range of 290 deg. C to 390 deg. C is adopted for the pyrolyzing. When a temperature lower than 290 deg. C is adopted as the pyrolyzing temperature, even if heating is kept for a long time enough, pyrolyzing hardly occurs, thereby, productivity will be missing, and good capacitor properties cannot be obtained. Meanwhile, as the dielectric film is formed on the surface of the second electrically conductive layer, when heating is performed at a temperature higher than 390 deg. C, oxidation of the surface of the second electrically conductive layer will be remarkable at the interface between the dielectric film and the second electrically conductive layer. However, when considering the variation in the step and the safety of quality during mass-production, it is preferable to adopt a temperature of around 370 deg. C, that is lower than 390 deg. C, as the upper limit. And, although heating time should be determined according to an adopted pyrolyzing temperature and the property of the sol-gel solution, providing that the above mentioned range of the heating temperature is adopted, if the heating was performed for less than five minutes, sufficient pyrolyzing cannot be performed. Moreover, if the heating time is longer than 30 minutes, oxidization of the second electrically conductive layer surface will proceed, even within the above-mentioned temperature range.

The above mentioned step (b) is a process repeating plurality of times, and the film thickness is adjusted so as to be a desired thickness. With regard to the conditions of drying and pyrolyzing in repeating, similar conditions as that mentioned above can be adopted.

(c) A baking step of subjecting the film to baking treatment under conditions of an inert-gas replaced atmosphere at a temperature of 550 deg. C to 800 deg. C for 10 minutes to 40 minutes to complete a dielectric layer. Being subjected to the baking step, the film finally becomes to a dielectric layer. In the baking step, in order to prevent oxidation of the second electrically conductive layer that is a metallic material, heating is performed in an inert-gas replaced atmosphere. As for the heating temperature at that time, the conditions of a temperature of 550 deg. C to 800 deg. C for 10 minutes to 40 minutes are adopted. In case of heating at a temperature lower than that of this temperature condition, sintering hardly occurs, and a good dielectric film that is excellent in adhesion with respect to the second electrically conductive layer and suitably enlarged oxide crystal texture cannot be obtained. In addition, when excessive heating at a temperature higher than this temperature conditions is performed, degradation of the dielectric film and degradation of physical strength of the second electrically conductive layer proceed. As a result, a capacitor layer forming material excellent in mechanical strength cannot be obtained and high electric capacitance and life span extension of the capacitor which are capacitor properties cannot be achieved.

(d) A first electrically conductive layer forming step of forming a first electrically conductive layer on the obtained dielectric layer to complete a capacitor layer forming material. In this step, as a methods of forming the first electrically conductive layer on the obtained dielectric layer, a method of using metal foils and laminate it onto, a method of forming a conductive layer by means of a plating, a method of sputter deposition and the like can be adopted.

### (Printed wiring board using the capacitor layer forming material according to the present Invention)

The capacitor layer forming material according to the present invention can be suitably used for forming an embedded capacitor layer of a multilayer printed wiring board. The first and second electrically conductive layers located on both sides of the capacitor layer forming material are etched to be the shape of a capacitor circuit, and they are used as materials constituting the multilayer printed wiring board. Moreover, by using the above mentioned nickel or nickel alloy as the second electrically conductive layer, it is possible to form a bottom electrode excellent in adhesion with the dielectric layer, and since the bottom electrode is made with a material excellent in heat resistance, even if the bottom electrode is subjected to plurality of hot pressing at a range of 300 deg. C to 400 deg. C, oxidation degradation of the bottom electrode does not occur and change in physical propertiesalsohardlyoccurs. Withregardtoamanufacturing method of the printed wiring board including an embedded capacitor circuit using the capacitor layer forming material according to the present invention, there is no limitation in particular, and thereby, all methods can be adopted for the manufacturing method.

### EXAMPLE 1

### <Manufacturing of a foil for a second electrically conductive layer>

Here, a nickel foil manufactured by means of a rolling process and having a thickness of 50 micron meter was used. The thickness of the nickel foil manufactured by means of the rolling process is shown as a gauge thickness.

### <Manufacturing of a capacitor layer forming material>

The above mentioned nickel foil was used for forming a second electrically conductive layer used for forming a bottom electrode of a capacitor layer forming material, and a dielectric layer was formed on the surface of the nickel foil by means of a sol-gel process. As a pretreatment, the nickel foil before the dielectric layer was formed thereon by means of the sol-gel process, was subjected to heating at 250 deg. C for fifteen minutes, and irradiated with an ultraviolet ray for 1 minute.

(a) In the solution preparing step, a sol-gel solution used for the sol-gel process was prepared. Here, by using ST-06 made by Kojundo Chemical Laboratory Co., Ltd. (3 wt% to 4 wt% of strontium oxide, 2 wt% to 3 wt% of titanium oxide (IV), 65 wt% to 70 wt% of isoamyl acetate, 6 wt% to 10 wt% of 1-butanol, 13 wt% to 15 wt% of organic material based stabilizing agent, and viscosity modifier etc.), and Mn-03 made by Kojundo Chemical Laboratory Co., Ltd. (2.8 wt% to 3. 2 wt% of manganese oxide (III), 44 wt% to 46 wt% of turpentine oil, 22 wt% to 24 wt% of butyl acetate, 7 wt% to 8 wt% of ethyl acetate, 10 wt% to 11 wt% of organic material based stabilizing agent, and viscosity modifier etc.), the sol-gel solution is prepared so as to obtain a SrTiO₃ oxide dielectric film of desired composition. In addition, when manganese was not contained, Mn-03 was not used.

(b) The sol-gel solution is coated on the surface of the nickel foil by using a spin coater, the coated solution is dried in an oxygen containing atmosphere (air atmosphere) at 150 deg. C for 2 minutes, and the dried coat is pyrolyzed in an air atmosphere at 330 deg. C for 15 minutes, and further the process is repeated for 6 times, a film thickness of the coated foil was adjusted.

(c) And the dielectric layers with various components were formed by subjecting the film to baking treatment in an inert-gas (nitrogen) replaced atmosphere at 650 deg. C for 15 minutes. In the examples, plurality of dielectric layers with manganese content within a range of 0 mol% to 3.00 mol% were formed on the surface of the second electrically conductive layer.

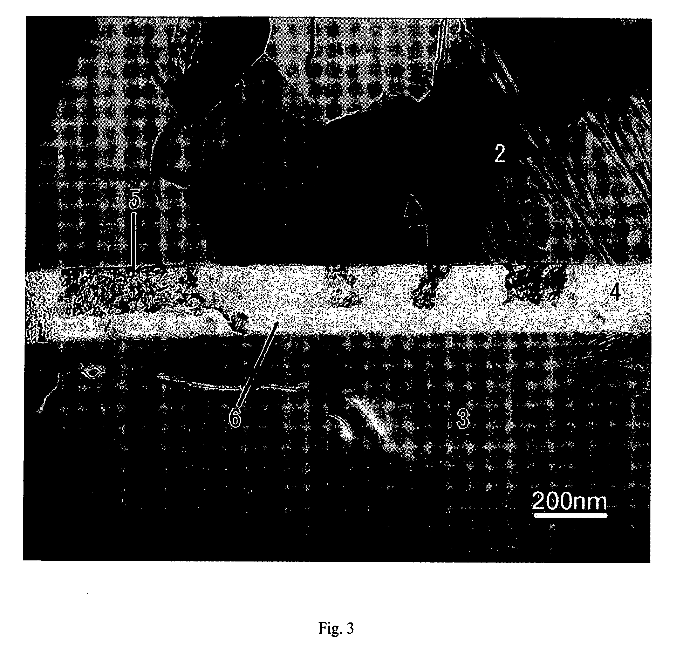

(d) On the dielectric layer formed as mentioned above, a copper layer whose thickness was 2 micron meter was formed as a first electrically conductive layer by means of a sputter deposition process to make eight kinds of capacitor layer forming materials in each of which both sides of a dielectric layer comprise a first electrically conductive layer and a second electrically conductive layer. In this stage, a dielectric strength between layers was measured by applying a predetermined voltage, short phenomenon between the first and the second electrically conductive layers was not observed. The grain size of enlarged crystal of an oxide texture contained in the dielectric layer of eachof these capacitor layer forming materials was within a range of 55 nano meter to 300 nano meter. A typical image of the cross-section of a capacitor layer forming material 1 according to the present invention observed by transmission electron microscope is shown in Figure 3. In the figure, a dielectric layer 4 is located between the top electrode 2 and the bottom electrode 3, and enlarged grain parts 5 and fine grain parts 6 are present in the oxide texture of the dielectric layer 4 in a mixed manner, thus, the grain size of the enlarged grain parts 5 can be understood.

As the results, when the electrode area of the top electrode was set to 1 mm², initial average capacitance density showed very high values, 600 nF/cm² to 1600 nF/cm². Moreover, as for dielectric strength of the dielectric films, while they were 3 V to 4 V in a case of dielectric films obtained by means of a conventional sol-gel process, they were equal to or greater than 6 V, and, it can be seen that good dielectric strength properties of the dielectric layers were obtained. The data of the eight samples are shown in Table 1.

### COMPARATIVE EXAMPLE

In a comparative example described here, a similar method as that of Example 1 was adopted, except that the manganese content was set to 5 mol% when the dielectric layer by means of the sol-gel process of Example 1 was formed. Accordingly, since description will be duplicated, description regarding to steps will be eliminated, and only description regarding to performance evaluation results will be given.

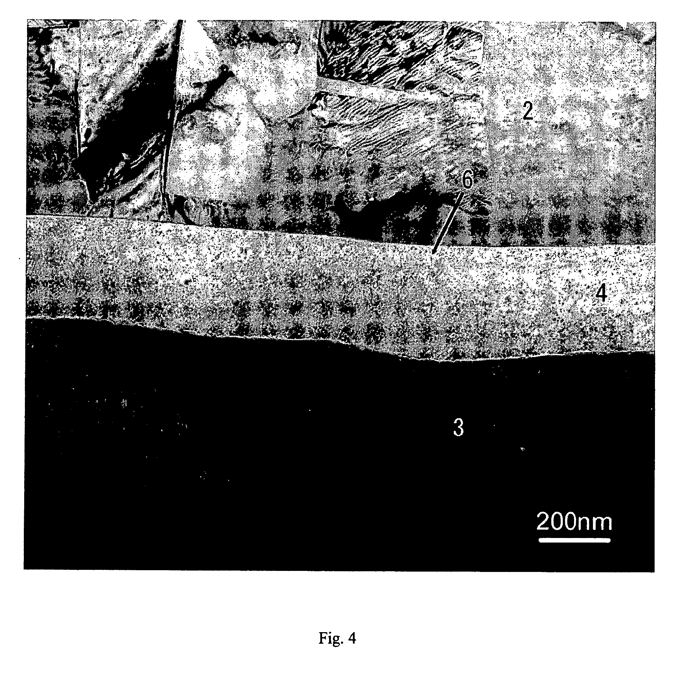

With regard to the grain size of oxide texture contained in the obtained dielectric layer of the capacitor layer forming material, substantially no clear enlarged crystal was observed. In Figure 4, a typical image of the cross-section of a capacitor layer forming material 1 manufactured in the comparative example observed by transmission electron microscope is shown. In the figure, a dielectric layer 4 is located between a top electrode 2 and a bottom electrode 3, and enlarged grain parts 5 are not observed in the oxide texture of the dielectric layer 4 and only fine grain parts 6 are present.

As the results, when the electrode area of the top electrode was set to 1 mm², initial average capacitance density showed a lower value, 450 nF/cm², than those of the example. Moreover, dielectric strength of the dielectric layer is 4V, and it can be seen that the level of dielectric strength properties of the dielectric layer is similar to those of conventional one. The data is shown in Table 1 together with the data of Example 1.

**Table 1**

| Sample No. | | Kinds of Oxide Dielectric Layer used as Dielectric Layer | Manganese Content | Dielectric Strength | Average Capacitance Density | Grain Size of Enlarged Grain | |
|---|---|---|---|---|---|---|---|
| | | | | | | Range of Grain Size | Average Grain Size |
| | | | mol % | V | nF/cm² | nanometer | |
| Example | 1 | SrTiO₃ | 0 | 6.0 | 1189 | 120-250 | 175 |
| | 2 | | 0.01 | 6.5 | 1228 | 140-275 | 186 |
| | 3 | | 0.25 | 7.0 | 1235 | 150-275 | 191 |
| | 4 | | 0.75 | 8.7 | 1574 | 190-300 | 287 |
| | 5 | | 1.00 | 10.5 | 924 | 105-175 | 145 |
| | 6 | | 1.25 | 9.5 | 844 | 80-140 | 128 |
| | 7 | | 2.00 | 7.0 | 657 | 75-125 | 107 |
| | 8 | | 3.00 | 6.0 | 618 | 55-115 | 83 |
| Comparative Example | | | 5.00 | 4.0 | 450 | No enlarged grain | |

### Industrial Applicability

In a capacitor layer forming material according to the present invention, by adopting an oxide dielectric film containing enlarged oxide grains formed by means of a sol-gel process as a dielectric layer locating between a first electrically conductive layer and a second electrically conductive layer, a leakage current of a capacitor circuit manufactured using the capacitor layer forming material can be reduced, thus it enables to achieve high capacitance and life-span extension of a capacitor circuit. Further, by adding 0.01 mol% to 3.00 mol% manganese to the capacitor forming material, the leakage current is further reduced, thus enabling life-span extension of the capacitor circuit. Accordingly, printed wiring boards etc. obtained by using the capacitor layer forming material contribute to power-saving of electron and electric products. Moreover, by adopting a manufacturing method of the capacitor layer forming material according to the present invention, efficient manufacturing of the capacitor layer forming material by means of a sol-gel process which does not require excessive plant and equipment investment can be achieved. Therefore, it becomes possible to supply electric and electronic products with a reasonable price and a high quality to the market.

## Claims

1. A capacitor layer forming material comprising a dielectric layer between a first electrically conductive layer used for forming a top electrode and a second electrically conductive layer used for forming a bottom electrode, **characterized in that**
the dielectric layer of an oxide dielectric film formed by means of a sol-gel process, has an enlarged crystal texture growing in the thickness direction and the plane direction of the dielectric layer, and includes an oxide crystal texture whose grain size (longitudinal diameter) is 50 nano meter to 300 nano meter.

2. The capacitor layer forming material according to claim 1, wherein the oxide dielectric film constituting the dielectric layer contains one or mixture selected from manganese, silicon, nickel, aluminum, lanthanum, niobium, and magnesium, at an amount of 0.01 mol% to 3.00 mol%.

3. The capacitor layer forming material according to claim 1 or 2, wherein the thickness of the dielectric layer is 20 nano meter to 1 micron meter.

4. The capacitor layer forming material according to claims 1 to 3, wherein the oxide dielectric film is any one of a (Ba₁₋ₓSrₓ)TiO₃ (0 ≦ x ≦ 1) film and a BiZrO₃ film.

5. The capacitor layer forming material according to claims 1 to 4, wherein the second electrically conductive layer is a nickel layer or a nickel alloy layer whose thickness is 10 micron meter to 100 micron meter.

6. The capacitor layer forming material according to claim 5, wherein the nickel alloy layer is a nickel-phosphorus alloy.

7. A manufacturing method of the capacitor layer forming material according to any one of claims 1 to 6, **characterized by** including:
(a) a solution preparing step of preparing a sol-gel solution for manufacturing a desired oxide dielectric film; and
(b) a coating step to adjust a film thickness by repeating plurality of times of a step which include coating of the sol-gel solution on the surface of a metal foil to be a second electrically conductive layer, drying of the coated solution under conditions of an oxygen containing atmosphere at a temperature of 120 deg. C to 250 deg. C for 1 minute to 10 minutes, and pyrolyzing under conditions of an oxygen containing atmosphere at a temperature of 290 deg. C to 390 deg. C for 5 minutes to 30 minutes; and
(c) a baking step to finish a dielectric layer by subjecting the film to baking treatment under conditions of an inert-gas replaced atmosphere, at a temperature of 550 deg. C to 800 deg. C for 10 minutes to 40 minutes; and
(d) a first electrically conductive layer forming step to complete a capacitor layer forming material by forming a first electrically conductive layer on the obtained dielectric layer.

8. A printed wiring board comprising an embedded capacitor layer obtained by using the capacitor layer forming material according to any one of claims 1 to 6.
